# EUROPÄISCHE PATENTSCHRIFT

(11) **EP 1 397 527 B1**
(45) Veröffentlichungstag und Bekanntmachung des Hinweises auf die Patenterteilung: **27.10.2004**
(21) Anmeldenummer: 02753070.8
(22) Anmeldetag: 21.06.2002
(51) Int. Cl.: C23C 16/30, H01F 1/18, C21D 8/12, C22C 38/02

(54) **KORNORIENTIERTES ELEKTROBLECH MIT EINER ELEKTRISCH ISOLIERENDEN BESCHICHTUNG**
GRAIN ORIENTED ELECTRIC SHEET OF METAL WITH AN ELECTRICALLY INSULATING COATING
TOLE ELECTRIQUE A CRISTAUX ORIENTES DOTEE D'UN REVETEMENT ELECTRIQUEMENT ISOLANT

(30) Priorität: 22.06.2001 DE 10130308
(43) Veröffentlichungstag der Anmeldung: 17.03.2004
(73) Patentinhaber: ThyssenKrupp Electrical Steel EBG GmbH, D-44791 Bochum (DE)
(72) Erfinder: SCHUHMACHER, Bernd, 44227 Dortmund (DE); GÜNTHER, Klaus, 46562 Voerde (DE); HINGMANN, Hermann, 46539 Dinslaken (DE); BEWILOGUA, Klaus, 38110 Braunschweig (DE); KLAGES, Claus-Peter, 38102 Braunschweig (DE); DIMIGEN, Heinz, 22605 Hamburg (DE); JUNG, Thomas, 38173 Hötzum (DE)
(74) Vertreter: Simons, Johannes, Dipl.-Ing.
(86) Internationale Anmeldenummer: PCT/EP2002/006869
(87) Internationale Veröffentlichungsnummer: WO 2003/000951

(56) Entgegenhaltungen:
- EP-A- 0 555 867
- EP-A- 0 600 533
- EP-A- 0 910 101
- WO-A-00/47402
- WO-A-99/47346
- DE-A- 19 825 860
- DE-A- 19 834 968

## Beschreibung

Die Erfindung betrifft ein neues kornorientiertes Elektroblech mit einer elektrisch isolierenden Beschichtung, welche nach der Schlussglühung aufgetragen wird, um für die Verwendung des kornorientierten Elektroblechs, z. B. in Transformatoren, die elektrische Isolierung der einzelnen Blechschichten zu gewährleisten. Die Erfindung betrifft ferner ein Verfahren zur Herstellung des kornorientierten Elektroblechs mit einer elektrisch isolierenden Beschichtung.

Wichtig für die weitere Verwendung, z. B. in Transformatoren, ist die Absenkung des Ummagnetisierungsverlustes. Eine gängige Maßnahme hierfür stellt das Zulegieren von Silizium dar, wodurch der spezifische elektrische Widerstand erhöht wird und damit die Wirbelstromverluste vermindert werden. Durch Modifikationen der chemischen Zusammensetzung und der Kaltwalz- und Glühprozesse wird die Kristallorientierung {110}<001> eingestellt und verschärft. Durch Verminderung der Blechdicke wird der Verlust weiter verbessert. Außerdem werden durch die Verbesserung der Reinheit des Stahls ausgeschiedene Partikel im Fertigprodukt vermieden, die als störende Haftstellen die Blochwandbewegung beim Ummagnetisieren behindern.

Elektroblechsorten mit besonders scharfer Orientierung und deshalb hoher Permeabilität können im Ummagnetisierungsverlust noch weiter verbessert werden, indem das Herstellungsverfahren so gesteuert wird, dass für eine Begrenzung der Größe der sekundärrekristallisierten Körner bzw. ein großes Verhältnis von Korngrenzenlänge zur Kornfläche gesorgt ist, und damit der Blochwandabstand vermindert wird. Zum Stand der Technik gehört auch, dass man die Domänenstruktur zusätzlich verbessert durch das Aufbringen einer Isolationsschicht, die auf das Blechsubstrat eine permanente Zugspannung ausübt, und zusätzlich durch Behandlungen, die Linien lokaler Spannungen quer oder schräg zur Walzrichtung erzeugen. Dieses können u.a. lokale mechanische Deformationen (EP 0 409 389 A2), Laser- oder Elektronenstrahlbehandlungen (EP 0 008 385 B1; EP 0 100 638 B1; EP 0 571 705 A2) oder das Einätzen von Gräben sein (EP 0 539 236 B1).

Ein Nachteil dieses Herstellweges für besonders verlustarme Elektroblechsorten ist die kostenaufwendige Kombination von Maßnahmen zur Isolationsschichtbildung und weiteren Domänenverfeinerung. Ein weiterer Nachteil ist, dass die Isolationsschicht üblicherweise in einer Folge von komplizierten, sorgsam aufeinander abgestimmten Verfahrensschritten aufgebaut wird, wodurch der Spielraum äußerst eingeengt wird, um noch weitere Parametervariationen für ökonomische und qualitative Verfahrensoptimierungen vornehmen zu können.

Der Aufbau der bisher üblichen spannungsausübenden Schicht geschieht, indem das auf Enddicke kaltgewalzte Band einer Glühung zur Primärrekristallisation und Entkohlung ausgesetzt wird, wobei die Oberfläche gezielt oxidiert wird, dann mit MgO und geeigneten Additiven als Klebschutz beschichtet und getrocknet wird, anschließend zum Coil aufgewickelt und zum Zweck der Sekundärrekristallisation und anschließenden Reinigung des Stahls von ausscheidungsbildenden Elementen erneut geglüht wird. Während dieses Glühschrittes reagiert die Klebschutzbeschichtung mit den Oxiden auf der Bandoberfläche und bildet eine Forsteritschicht (Mg₂SiO₄), die auch als "Glasfilm" bezeichnet wird. Dieser Film geht mit Verwurzelungen in das Grundmaterial über, was für seine Haftung günstig ist. Auf ihn werden in einem weiteren Verfahrenschritt, wie beispielsweise aus der DE 22 47 269 C3 bekannt ist, Lösungen auf der Basis von Magnesiumphosphat oder Aluminiumphosphat oder Mischungen von beiden mit verschiedenen Zusätzen wie beispielsweise Chromverbindungen und Si-Oxid aufgebracht und bei Temperaturen oberhalb 350°C eingebrannt. Die durch die fertige Isolationsschicht auf das Grundmaterial übertragene Zugspannung kann bis zu etwa 5 MPa betragen. Die damit erzielten Verbesserungen des Ummagnetisierungsverlustes liegen in der Größenordnung von rd. 5%. Außerdem sinkt die Magnetostriktion.

Begrenzt wird die erzielbare Verlustverbesserung durch den Umstand, dass für den Aufbau der Schicht Oxidationsprozesse unerlässlich sind, bei denen sich an der Oberfläche bzw. in den Oberflächenzonen nichtferromagnetische Partikel und Inhomogenitäten bilden, welche die Beweglichkeit der Blochwände beim Ummagnetisieren beeinträchtigen und damit erhöhte Energieverluste bewirken.

In neueren Entwicklungen ist deshalb versucht worden, Elektrobleche ohne Glasfilm und mit möglichst glatter Oberfläche zu erzeugen, und nachträglich spannungsausübende Isolationsschichten aufzubringen, die keine Oberflächenoxidation als Grundlage benötigen. Erprobt wurden beispielsweise Sol-Gel-Verfahren für Beschichtungen mit oxidischen Substanzen, wie sie in EP 0 555 867 A2 beschrieben werden, wobei die Schichtspannungen aufgrund der Unterschiede in den thermischen Ausdehnungskoeffizienten zwischen Stahl und Schicht und der hohen Temperatur von 800°C bis 1000°C bei der Schichtbildung erzeugt worden sind. Weitere bekannte Verfahren sind das Aufbringen dünner Schichten auf Blechsubstraten aus Elektroblech mit extrem glatter Oberfläche mittels CVD- oder PVD-Verfahren wie die Elektronenstrahlverdampfung, Magnetronsputtern oder Vakuumlichtbogenverdampfung, wobei Schichten bzw. Mehrlagenschichten aus Metallnitriden oder -carbiden (z.B. TiN, BN, ZrN, AlN, Ti(CN), Cr2N, TiC, ZrC, WC) hergestellt werden, wie in EP 0 193 324 B1 oder EP 0 910 101 A1 beschrieben ist.

Mit derartigen Schichten sind Zugspannungen im Elektroblech von beispielsweise 8 MPa erzeugbar, jedoch ist ihre unzureichende elektrische Isolationswirkung nachteilig, so dass sie noch mit einer zusätzlichen isolierenden Schicht überdeckt werden müssen, wie in der EP 0 215 134 B1 beschrieben ist.

Der Erfindung liegt die Aufgabe zugrunde, ein hochpermeables kornorientiertes Elektroblech zu erzeugen, das als Kernwerkstoff für besonders geräusch- und verlustarme Transformatoren geeignet ist.

Die Aufgabe wird gelöst durch ein kornorientiertes Elektroblech nach Anspruch 1 mit einer elektrisch isolierenden Beschichtung aus einem amorphen Kohlenstoff-Wasserstoff-Netzwerk.

Erfindungsgemäßes kornorientiertes Elektroblech ist mit einer Beschichtung versehen ist, die eine so hohe Zugspannung auf das Blech ausübt und den Ummagnetisierungsverlust so weit verbessert, dass zusätzliche Maßnahmen zur Verfeinerung der magnetischen Domänenstruktur überflüssig werden. Die erfindungsgemäß aus einem amorphen Kohlenstoff-Wasserstoff-Netzwerk gebildete Beschichtung haftet sicher auf der Bandoberfläche und besitzt einen hohen Oberflächenisolationswiderstand.

Amorphe Kohlenstoff-Wasserstoff-Netzwerke, auch bekannt als a:C-H oder diamond-like carbon (DLC) sind bekanntermaßen sehr hart, chemisch inert und haften gut auf Stahllegierungen, wie beispielsweise in der EP 0 600 533 B1 beschrieben ist. Diese Eigenschaften werden bisher, wie z. B. in DE 198 34 968 Al oder WO 99/47346 A1 beschrieben, für Beschichtungen von Werkzeugen genutzt, die besonderen Anforderungen hinsichtlich ihrer Adhäsionswirkung genügen müssen. Die gleiche Eignung steht bei dem aus der DE 198 25 860 A1 bekannten Stand der Technik bei der Beschichtung von Kolbenringen im Vordergrund.

Überraschenderweise hat sich herausgestellt, dass ein in erfindungsgemäßer Weise mit einer Beschichtung aus einem amorphen Kohlenstoff-Wasserstoff-Netzwerk versehenes Elektroblech erheblich verbesserte magnetische Eigenschaften, wie verringerten Ummagnetisierungsverlust und höhere magnetische Polarisation, aufweist. Dies ist vermutlich auf die beobachtete Verfeinerung der magnetischen Domänenstruktur zurückzuführen, welche eine zusätzliche Behandlung des Elektroblechs zur Domänenfeinung überflüssig macht.

Ferner wird für erfindungsgemäße Elektrobleche eine Unempfindlichkeit der magnetische Eigenschaften gegenüber Druckspannungen, wie sie in Transformatorkernen auftreten können, erreicht. Ein weiterer damit verbundener Vorteil liegt in der verringerten Magnetostriktion, die den Bau geräuschärmerer Transformatoren erlaubt. Zudem ist das erfindungsgemäße Schichtsystem dünner als konventionelle Schichtsysteme, was einen höheren Stapelfaktor im Transformatorkern zulässt.

Die elektrisch isolierende Beschichtung des kornorientierten Elektroblechs kann mit einem oder mehreren der Elemente Si, O, N, B oder F, vorzugsweise jeweils in Höhe von 1 bis 20 Atomprozent, dotiert sein.

Besondere gute magnetische Eigenschaften des Elektroblechs werden dadurch erzielt, dass die elektrisch isolierende Beschichtung eine Zugspannung von mindestens 8 MPa auf das Blechsubstrat ausübt.

Zur weiteren Verbesserung der Haftung zwischen Blechsubstrat und dem amorphen Kohlenstoff-Wasserstoff-Netzwerk ist es vorteilhaft, zwischen der elektrisch isolierenden Beschichtung und dem Blechsubstrat mindestens eine haftungsverbessernde Zwischenschicht anzuordnen. Diese haftungsverbessernde Zwischenschicht kann beispielsweise aus einem Si-C-O-H-Netzwerk oder einem Si-C-H-Netzwerk bestehen.

Als weitere haftungsverbessernde Zwischenschichten kommen Titan oder titanhaltigen Verbindungen in Frage, insbesondere Titannitrid, wodurch die Zugspannung auf das Blechsubstrat weiter verstärkt werden kann.

Bevorzugt weist die Beschichtung eines erfindungsgemäßen Elektroblechs einen Oberflächenisolationswiderstand von mindestens 10 Ohm*cm² auf, wodurch die erforderliche Isolationswirkung gewährleistet wird.

Erfindungsgemäßes kornorientiertes Elektroblech weist bei entsprechender Optimierung bei einer Blechdicke von 0,30 mm einen Ummagnetisierungsverlust (bei einer Frequenz von 50 Hertz und eine Polarisation von 1,7 Tesla) von P_{1,7} ≤ 0,90 W/kg, bei einer Blechdicke von 0,27 mm von P_{1,7} ≤ 0,80 W/kg und bei einer Blechdicke von 0,23 mm von P_{1,7} ≤ 0,70 W/kg auf.

Das Blechsubstrat enthält als typische Zusammensetzung 2,5 Gew.-% bis 4,0 Gew.-% Silizium, bis zu 0,20 Gew.-% Mangan, bis zu 0,50 Gew.-% Kupfer, bis zu 0,065 Gew.-% Aluminium, bis zu 0,0150 Gew.-% Stickstoff und mindestens 90 Gew.-% Eisen. Darüber hinaus können zusätzlich eines oder mehrere der Elemente Cr, Ni, Mo, P, As, Sn, Sb, Se, Te, B oder Bi mit Massengehalten jeweils bis zu 0,2 Gew.-% enthalten sein.

Das Blechsubstrat wird erzeugt aus einer Stahlschmelze, wie sie typischerweise zur Herstellung von kornorientierten Elektroblechen eingesetzt wird, die 2,5 Gew.-% bis 4,0 Gew.-% Si, bis zu 0,100 Gew.-% C, bis zu 0,20 Gew.-% Mn, bis zu 0,50 Gew.-% Cu, bis zu 0,035 Gew.-% S, bis zu 0,065 Gew.-% Al, bis zu 0,0150 Gew.-% N, Rest hauptsächlich Fe und übliche Verunreinigungen sowie die vorgenannten zusätzlichen Legierungselemente Cr, Ni, Mo, P, As, Sn, Sb, Se, Te, B oder Bi mit Massengehalten jeweils bis zu 0,2 Gew.-% enthält, durch Bandgießen oder durch Stranggießen von Brammen von 20 bis 300 mm Dicke. Diese werden anschließend zu Warmband ausgewalzt, wonach ein optionales Glühen des Warmbandes erfolgen kann. Das nachfolgende ein- oder mehrmalige Kaltwalzen erfolgt mit Zwischenglühen auf eine Enddicke von 0,15 bis 0,50 mm. Daran schließen sich eine primär rekristallisierende Glühung mit entkohlenden Bedingungen, solange der Massengehalt an Kohlenstoff im Stahl mehr als 0,005 Gew.-% beträgt, sowie gegebenenfalls ein Aufbringen eines Klebschutzes, gefolgt von einer Glühung zur Sekundärrekristallisation und Goss-Texturbildung (Hochglühung), einer Glühung zur Reinigung des Stahls von den zur Steuerung der Rekristallisation und Texturbildung nicht mehr benötigten Elementen (Schlussglühung) , gegebenenfalls Entfernung der Klebschutzreste und der bei den vorausgegangenen Glühungen gebildeten Oxide von den Bandoberflächen. Besonders vorteilhaft sind Prozessbedingungen, die eine glasfilmfreie Oberfläche des Blechsubstrats sicherstellen, um ein Entstehen und nach der Hochglühung erforderliches Entfernen des Glasfilms zu vermeiden.

Eine weitere bevorzugte Variante der Herstellung des Blechsubstrats ist die Glühung zur Sekundärrekristallisation mit Goss-Texturbildung, die als kontinuierliche Glühung im Banddurchlaufofen mit maximal 15 min Dauer ausgeführt wird. Bevorzugt wird in diesem Zusammenhang auch die Glühung zur Reinigung des Stahls als kontinuierliche Glühung im Banddurchlaufofen mit maximal 15 min Dauer ausgeführt. Diese Verfahrensschritte erzielen hinsichtlich der Prozessoptimierung das beste Resultat, wenn die erfindungsgemäßen Oberflächenbeschichtungen direkt in Linie mit der Banddurchlaufofenglühung ausgeführt werden.

Günstig beeinflusst kann das verwendete Blechsubstrat auch dadurch werden, dass es zwischen dem ersten Kaltwalzen und der Sekundärrekristallisation aufstickenden Glühbedingungen ausgesetzt wird. Dies kann durch Zusatz von NH₃ zum Glühgas erfolgen. Alternativ dazu kann das Band mittels geeigneter stickstoffspendender Additive zum Klebschutz aufgestickt werden.

Ein geeignetes Verfahren zur Herstellung von erfindungsgemäßem kornorientiertem Elektroblech mit einer elektrisch isolierenden Beschichtung aus einem amorphen Kohlenstoff-Wasserstoff-Netzwerk besteht darin, dass die Beschichtung des bandförmigen Blechsubstrats mit der elektrisch isolierenden Beschichtung in einem kontinuierlichen Banddurchlaufverfahren erfolgt. Zweckmäßigerweise erfolgt auch das Aufbringen von haftungsverbessernden Zwischenschichten in einem kontinuierlichen Banddurchlaufverfahren, das bevorzugt der Durchlaufbeschichtung mit dem amorphen Kohlenstoff-Wasserstoff-Netzwerk in Linie vorgeschaltet ist.

Als Beschichtungsverfahren kommen sowohl für die Beschichtung mit einem amorphen Kohlenstoff-Wasserstoff-Netzwerk als auch für die Aufbringung der haftungsverbessernden Zwischenschichten entweder CVD (chemical vapour deposition)-Verfahren oder PVD (physical vapour deposition)-Verfahren in Betracht. Bei den CVD-Verfahren kommen Verfahren mit thermischer Aktivierung oder Plasmaaktivierung und besonders bevorzugt Hohlkathoden-Glimmentladungsverfahren in Betracht. Als PVD-Verfahren sind thermisches Verdampfen, Sputtern, bzw. Laser-, Elektronenstrahl- oder Bogen (ARC)-Verdampfung geeignet. Eine besonders bevorzugte Ausgestaltung des PVD-Verfahrens ist in der plasmaaktivierten Hochrate-Elektronenstrahlbedampfung zu sehen. Auch können die einzelnen Beschichtungsschritte mittels unterschiedlicher Verfahren erfolgen.

Vorteilhafterweise sollte die Oberfläche des Stahlsubstrats vor der Beschichtung eine Rauhigkeit Ra von maximal 0,5 µm aufweisen, da dies zu einer deutlichen Verbesserung der magnetischen Eigenschaften beiträgt.

Nachfolgend wird die Erfindung anhand von Ausführungsbeispielen näher erläutert. Es zeigen:

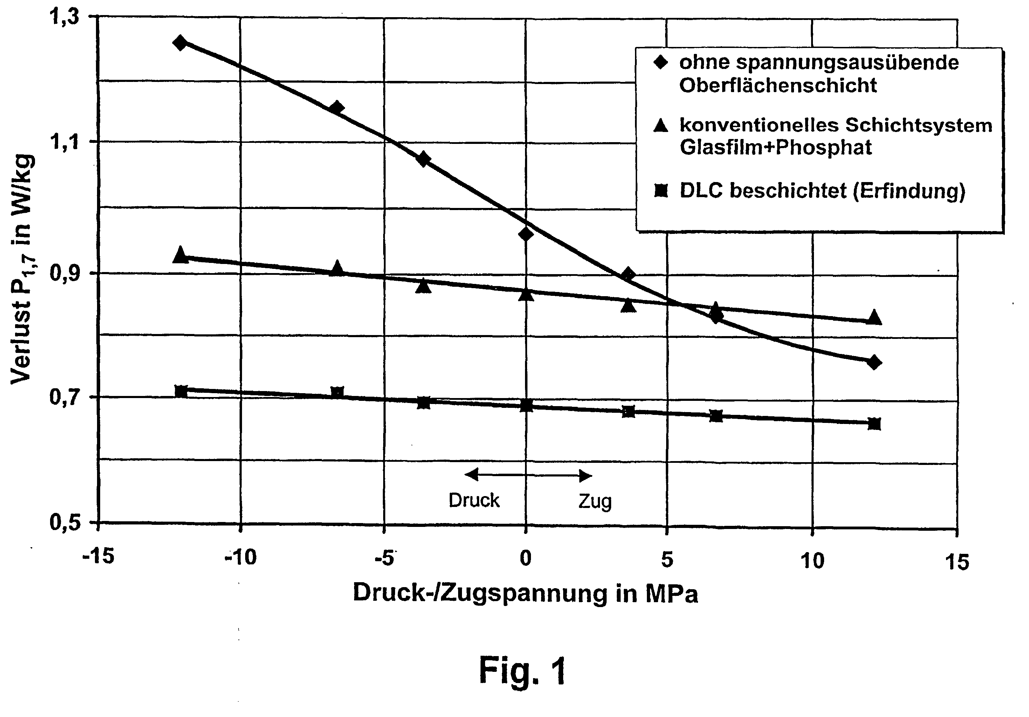

- Fig. 1: den über die äußeren Druck-/Zugspannungen aufgetragenen Ummagnetisierungsverlust für ein mit einer spannungsausübenden Oberflächenschicht beschichtetes Blech, für ein mit einem konventionellen Schichtsystem beschichtetes Blech und für ein erfindungsgemäß beschichtetes Blech,

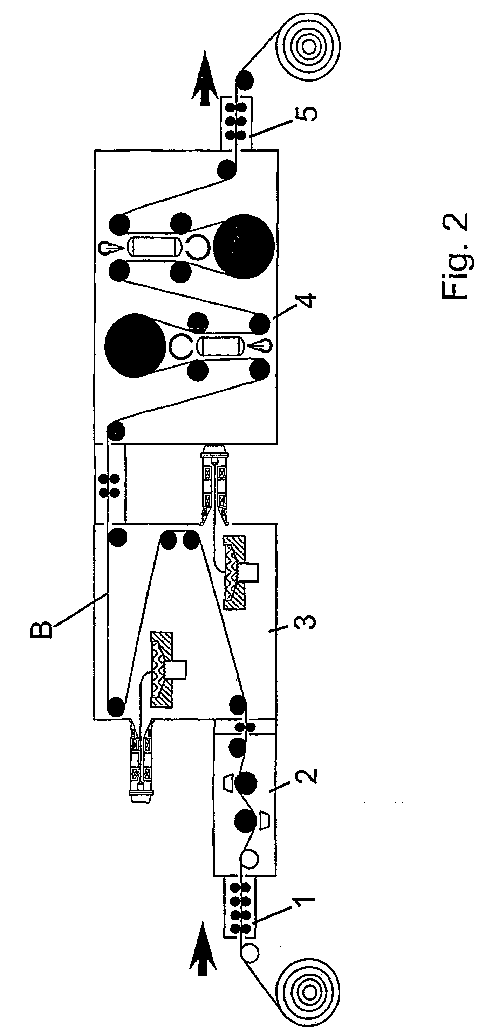

- Fig. 2: eine Vorrichtung zur zweiseitigen Beschichtung von kornorientierten Elektroblechen mit einer haftungsverbessernden Zwischenschicht und einer nachfolgenden elektrisch isolierenden Beschichtung aus einem amorphen Kohlenstoff-Wasserstoff-Netzwerk in einem kontinuierlichen Banddurchlaufverfahren in schematisch Darstellung.

In Tabelle 1 sind für Proben 1 bis 4 der jeweilige Beschichtungszustand, die aus der Krümmung einer einseitig beschichteten Probe (bei DLC einseitig beschichtet, bei konventioneller Isolation nachträglich einseitig von Isolation befreit) berechnete jeweilige Zugspannung, die jeweilige Blechdicke, der Ummagnetisierungsverlust P_{1,7} (ermittelt bei einer Frequenz von 50 Hz und einer Polarisation von 1,7 Tesla) und die magnetische Polarisation bei einer magnetischen Feldstärke von 800 A/m angegeben.

**Tabelle 1**

| Probe | Zustand | Zugspannung^{**)} [MPa] | Blechdicke [mm] | P_{1,7} W/kg | J₈₀₀ T |
|---|---|---|---|---|---|
| 1 | Referenz (herkömmliche Isolation) | 5 | 0,213 | 0,89 | 1,90 |
| 2*) | DLC-Schicht 1 µm | 12 | 0,220 | 0,84 | 1,90 |
| 3*) | DLC-Schicht 2 µm | 24 | 0,216 | 0,69 | 1,92 |
| 4*) | DLC-Schicht 2 µm | 24 | 0,221 | 0,71 | 1,93 |

| | | | | | |
|---|---|---|---|---|---|
| *) erfindungsgemäße Beispiele, | | | | | |
| **) berechnet aus der Krümmung einer einseitig beschichteten Probe (bei DLC einseitig beschichtet, bei konventioneller Isolation nachträglich einseitig von Isolation befreit). | | | | | |

Die Blechsubstrate wurden aus der betrieblichen Fertigung von hochpermeablem kornorientierten Elektroband mit herkömmlichem Glasfilm und Phosphatschicht entnommen (Probe 1). Die Entfernung der Phosphatschicht erfolgte mit 25 Gew.-% NaOH bei 60°C, der darunterliegende Glasfilm wurde mit HCl/HF-Gemisch entfernt. Anschließend wurde die Oberfläche geglättet durch eine chemische Politur in H₂O₂/HF-Gemisch.

Die Herstellung der Beschichtungen der Proben 2 wurde vorgenommen wie folgt:

Mittels einer durch eine Hohlkathodenentladung erzeugten intensiven Glimmentladung in einem Argon-Azetylen-Gemisch wird ein Plasma erzeugt, aus dem auf dem Elektroblech beidseitig eine amorphe Kohlenstoff- Wasserstoff-Schicht mit hoher Härte und hohen Druckeigenspannungen abgeschieden wird. Bevor diese Schicht aufgebracht wird, wird mit Hilfe der gleichen hohlkathoden-basierten Glimmentladung eine ca. 0,5 µm dicke haftvermittelnde amorphe Schicht, die aus Silicium, Kohlenstoff und Wasserstoff (Si-C:H) besteht, abgeschieden. Zur Abscheidung dieser Schicht wird statt Azetylen TMS (Tetramethyl-Silan) als Ausgangssubstanz verwendet.

Die so erzeugte amorphe Kohlenstoff-Wasserstoff-Schicht, in Tabelle 1 als DLC-Schicht abgekürzt, der Probe 2 hat eine Dicke von 1 µm. Aus der Durchbiegung einer nur einseitig beschichteten Referenzprobe wird für die Schicht eine Druckeigenspannung von 3 GPa ermittelt. Dadurch wird in dem Elektroblech von 0,25 mm Dicke eine Zugspannung von ca. 12 MPa erzeugt. Für den Flächenwiderstand dieser Schicht wird mit Hilfe eines Franklin-Testers ein Wert von ≥ 20 Ωcm ermittelt.

Die Herstellung der Beschichtungen der Proben 3 und 4 wurde folgendermaßen vorgenommen:

Mittels Hochfrequenzglimmentladung in einem Argon-Azetylen-Gemisch wird ein Plasma erzeugt, aus dem auf dem Elektroblech beidseitig eine amorphe Kohlenstoff-Wasserstoff-Schicht mit hoher Härte und hohen Druckeigenspannungen abgeschieden wird. Bevor diese Schicht aufgebracht wird, wird mittels Kathodenzerstäubung eine ca. 0,5 µm dicke haftvermittelnde Titan-Schicht abgeschieden. Der Übergang von der Titan-Beschichtung zur amorphen Kohlenstoff-Wasserstoff-Schicht erfolgt ohne Unterbrechung des Vakuums.

Die amorphe Kohlenstoff-Wasserstoff-Schicht der Proben 3 und 4 hat eine Dicke von 2 µm. Aus der Durchbiegung einer nur einseitig beschichteten Referenzprobe wird für die Schicht eine Druckeigenspannung von 3 GPa ermittelt. Dadurch wird in dem Elektroblech von 0,25 mm Dicke eine Zugspannung von ca. 25 MPa erzeugt. Für den Flächenwiderstand dieser Schicht wird mit Hilfe eines Franklin-Testers ein Wert von > 20 Ωcm ermittelt.

Die Abbildung der Domänenstruktur an ein und derselben Stelle einer Probe vor und nach der erfindungsgemäßen Beschichtung mit einem amorphen Kohlenstoff-Wasserstoff-Netzwerk zeigt eine leichte domänenverfeinernde Wirkung einer 1µm dicken, amorphen Kohlenstoff-Wasserstoff-Schicht und eine stark domänenverfeinernde Wirkung einer 2µm dicken, amorphen Kohlenstoff-Wasserstoff-Schicht.

Zur Ermittlung der Unempfindlichkeit gegenüber Druckspannungen wurde der Ummagnetisierungsverlust in Abhängigkeit von äußeren Zugspannungen (positive Werte) und Druckspannungen (negative Werte) gemessen. Die Resultate sind in Figur 1 dargestellt. Dabei sind die für ein nicht beschichtete Blech ermittelten Messwerte durch Rauten, die für ein mit einem konventionellen Schichtsystem Glasfilm + Phosphat ermittelten Messwerte durch Dreiecke und die für ein erfindungsgemäßes Blech ermittelten Messwerte durch Quadrate markiert.

In Figur 2 ist ein Beispiel einer Anlage zur zweiseitigen Beschichtung von kornorientierten Elektroblechen mit einer haftungsverbessernden Zwischenschicht und einer nachfolgenden darauf aufgebrachten elektrisch isolierenden Schicht aus einem amorphen Kohlenstoff-Wasserstoff-Netzwerk in einem kontinuierlichen Banddurchlaufverfahren schematisch dargestellt.

Nach dem Abhaspeln und Überführung in einen mittels Schleusen 1 abgeschotteten Hochvakuumbereich durchläuft ein Elektroblech-Band B zunächst eine Einrichtung 2 zur Plasmafeinreinigung, in der z.B. mittels magnetfeldverstärkter Glimmentladung in Ar-Atmosphäre eine Feinreinigung erfolgt.

Die haftungsverbessernde Zwischenschicht wird in einer anschließend vom Band B durchlaufenen Bedampfungseinrichtung 3 durch Hochrate-Elektronenstrahlbedampfung aufgebracht. Diese haftungsverbessernden Schichten bestehen z.B. aus Ti oder TiN. Bei letzterem kann vorteilhaft eine reaktive Variante des Elektronenstrahlbedampfens angewandt werden, in dem gezielt Stickstoff als Reaktivgas in den Vakuumrezipienten eingelassen wird. Vorteilhaft kann auch die Anwendung einer Plasmaaktivierung bei der Bedampfung sein.

Die Abscheidung der elektrisch isolierenden Schicht, bestehend aus einem amorphen Kohlenstoff-Wasserstoff-Netzwerk, erfolgt danach ohne Unterbrechung bei weiterhin aufrechterhaltenem Vakuum in einer Hohlkathoden-Glimmentladungseinrichtung 4. Besonders vorteilhaft ist hierbei die Anwendung einer Bandhohlkathode.

Danach wird das beschichtete Band B über eine Schleuse 5 aus dem Vakuumbereich ausgeschleust und wieder aufgehaspelt.

## Patentansprüche

1. Kornorientiertes Elektroblech mit einer elektrisch isolierenden Beschichtung aus einem amorphen Kohlenstoff-Wasserstoff-Netzwerk.

2. Kornorientiertes Elektroblech nach Anspruch 1, **dadurch gekennzeichnet, dass** die elektrisch isolierende Beschichtung mit mindestens einem der Elemente Si, O, N, B oder F dotiert ist.

3. Kornorientiertes Elektroblech nach Anspruch 2, **dadurch gekennzeichnet, dass** die Dotierungselemente in der elektrisch isolierenden Beschichtung in Höhe von 1 bis 20 Atomprozent enthalten sind.

4. Kornorientiertes Elektroblech nach einem der Ansprüche 1 bis 3, **dadurch gekennzeichnet, dass** die elektrisch isolierende Beschichtung eine Zugspannung von mindestens 8 MPa auf das Blechsubstrat ausübt.

5. Kornorientiertes Elektroblech nach einem der Ansprüche 1 bis 4, **dadurch gekennzeichnet, dass** zwischen der elektrisch isolierenden Beschichtung und dem Blechsubstrat mindestens eine haftungsverbessernde Zwischenschicht angeordnet ist.

6. Kornorientiertes Elektroblech nach Anspruch 5, **dadurch gekennzeichnet, dass** mindestens eine haftungsverbessernde Zwischenschicht aus einem Si-C-O-H-Netzwerk besteht.

7. Kornorientiertes Elektroblech nach einem der Ansprüche 5 oder 6 **dadurch gekennzeichnet, dass** mindestens eine haftungsverbessernde Zwischenschicht aus einem Si-C-H-Netzwerk besteht.

8. Kornorientiertes Elektroblech nach einem der Ansprüche 5 bis 7, **dadurch gekennzeichnet, dass** mindestens eine haftungsverbessernde Zwischenschichten aus Titan oder einer titanhaltigen Verbindung besteht.

9. Kornorientiertes Elektroblech nach Anspruch 8, **dadurch gekennzeichnet, dass** die titanhaltige Verbindung Titannitrid ist.

10. Kornorientiertes Elektroblech nach einem der Ansprüche 1 bis 9, **dadurch gekennzeichnet, dass** die Beschichtung einen Oberflächenisolationswiderstand von mindestens 10 Ohm*cm² aufweist.

11. Kornorientiertes Elektroblech nach einem der Ansprüche 1 bis 10, **dadurch gekennzeichnet, dass** es bei einer Blechdicke von 0,30 mm einen Ummagnetisierungsverlust (bei einer Frequenz von 50 Hertz und einer Polarisation von 1,7 Tesla) von P_{1,7} ≤ 0,90 W/kg, bei einer Blechdicke von 0,27 mm von P_{1,7} S 0,80 W/kg und bei einer Blechdicke von 0,23 mm von P_{1,7} ≤ 0,70 W/kg aufweist.

12. Kornorientiertes Elektroblech nach einem der Ansprüche 1 bis 11, **dadurch gekennzeichnet, dass** das Blechsubstrat 2,5 Gew.-% bis 4,0 Gew.-% Silizium, bis zu 0,20 Gew.-% Mangan, bis zu 0,50 Gew.-% Kupfer, bis zu 0,065 Gew.-% Aluminium, bis zu 0,0150 Gew.-% Stickstoff und mindestens 90 Gew.-% Eisen enthält.

13. Kornorientiertes Elektroblech nach Anspruch 12, **dadurch gekennzeichnet, dass** zusätzlich mindestens eines der Elemente Cr, Ni, Mo, P, As, Sn, Sb, Se, Te, B oder Bi mit jeweils bis zu 0,2 Gew.-% enthalten ist.

14. Verfahren zur Herstellung von kornorientiertem Elektroblech mit einer elektrisch isolierenden Beschichtung aus einem amorphen Kohlenstoff-Wasserstoff-Netzwerk nach einem der Ansprüche 1 bis 13, **dadurch gekennzeichnet, dass** die Beschichtung des bandförmigen Blechsubstrats mit der elektrisch isolierenden Beschichtung in einem kontinuierlichen Banddurchlaufverfahren erfolgt.

15. Verfahren nach Anspruch 14, **dadurch gekennzeichnet, dass** die Beschichtung des Blechsubstrats mit haftungsverbessernden Zwischenschichten gemäß den Ansprüchen 5 bis 9 in einem kontinuierlichen Banddurchlaufverfahren vor dem Aufbringen der elektrisch isolierenden Beschichtung erfolgt.

16. Verfahren nach einem der Ansprüche 14 oder 15, **dadurch gekennzeichnet, dass** mindestens einer der Beschichtungsschritte mittels eines CVD (chemical vapour deposition) - Verfahrens erfolgt.

17. Verfahren nach einem der Ansprüche 14 bis 16, **dadurch gekennzeichnet, dass** mindestens einer der Beschichtungsschritte mittels eines PVD (physical vapour deposition) - Verfahrens erfolgt.

18. Verfahren nach Anspruch 17, **dadurch gekennzeichnet, dass** mindestens einer der Beschichtungsschritte mittels eines plasmaaktivierten PVD-Verfahrens erfolgt.

19. Verfahren nach Anspruch 17 oder 18, **dadurch gekennzeichnet, dass** mindestens einer der Beschichtungsschritte mittels eines Hohlkathoden-Glimmentladungsverfahrens erfolgt.

20. Verfahren nach einem der Ansprüche 14 bis 19, **dadurch gekennzeichnet, dass** die Oberfläche des Stahlsubstrats vor der Beschichtung eine Rauhigkeit Ra von maximal 0,5 µm aufweist.

## Claims

1. A grain-oriented magnetic steel sheet comprising an electrically insulating coating made of an amorphous carbon-hydrogen network.

2. The grain-oriented magnetic steel sheet according to claim 1, **characterised in that**
the electrically insulating coating is doped with at least one of the elements Si, O, N, B or F.

3. The grain-oriented magnetic steel sheet according to claim 2,
**characterised in that**
the doping elements are contained in the electrically insulating coating in a range from 1 to 20 atomic per cent.

4. The grain-oriented magnetic steel sheet according to any one of claims 1 to 3,
**characterised in that**
the electrically insulating coating exerts a tensile stress of at least 8 MPa on the sheet substrate.

5. The grain-oriented magnetic steel sheet according to any one of claims 1 to 4,
**characterised in that**
at least one adhesion-improving intermediate layer is arranged between the electrically insulating coating and the sheet substrate.

6. The grain-oriented magnetic steel sheet according to claim 5,
**characterised in that**
at least one adhesion-improving intermediate layer consists of an Si-C-O-H network.

7. The grain-oriented magnetic steel sheet according to one of claims 5 or 6,
**characterised in that**
at least one adhesion-improving intermediate layer consists of an Si-C-H network.

8. The grain-oriented magnetic steel sheet according to any one of claims 5 to 7,
**characterised in that**
at least one adhesion-improving intermediate layer consists of titanium or a titaniferous compound.

9. The grain-oriented magnetic steel sheet according to claim 8,
**characterised in that**
the titaniferous compound is titanium nitride.

10. The grain-oriented magnetic steel sheet according to any one of claims 1 to 9,
**characterised in that**
the layer has a surface insulation resistance of at least 10 Ohm*cm².

11. The grain-oriented magnetic steel sheet according to any one of claims 1 to 10,
**characterised in that**
at a sheet thickness of 0.30 mm, it has a hysteresis loss (at a frequency of 50 Hertz and a polarisation of 1.7 Tesla) of P_{1.7} ≤ 0.90 W/kg; at a sheet thickness of 0.27 mm, of P_{1.7} ≤ 0.80 W/kg; and at a sheet thickness of 0.23 mm, of P_{1.7} ≤ 0.70 W/kg.

12. The grain-oriented magnetic steel sheet according to any one of claims 1 to 11,
**characterised in that**
the sheet substrate contains 2.5 weight % to 4.0 weight % silicon, up to 0.20 weight % manganese, up to 0.50 weight % copper, up to 0.065 weight % aluminium, up to 0.0150 weight % nitrogen, and at least 90 weight % iron.

13. The grain-oriented magnetic steel sheet according to claim 12,
**characterised in that**
additionally at least one of the elements Cr, Ni, Mo, P, As, Sn, Sb, Se, Te, B or Bi, at up to 0.2 weight % is present.

14. A method for producing grain-oriented magnetic steel sheet with an electrically insulating coating from an amorphous carbon-hydrogen network according to any one of claims 1 to 13,
**characterised in that**
coating of the strip-shaped sheet substrate with the electrically insulating coating takes place in a continuous strip method.

15. The method according to claim 14,
**characterised in that**
coating of the sheet substrate with adhesion-improving intermediate layers according to claims 5 to 9 takes place in a continuous strip method prior to the application of the electrically insulating coating.

16. The method according to one of claims 14 or 15,
**characterised in that**
at least one of the coating steps takes place by means of a CVD (chemical vapour deposition) method.

17. The method according to any one of claims 14 to 16,
**characterised in that**
at least one of the coating steps takes place by means of a PVD (physical vapour deposition) method.

18. The method according to claim 17,
**characterised in that**
at least one of the coating steps takes place by means of a plasma-activated PVD method.

19. The method according to claim 17 or 18,
**characterised in that**
at least one of the coating steps takes place by means of a hollow-cathode glow-discharge method.

20. The method according to any one of claims 14 to 19,
**characterised in that**
the surface of the steel substrate prior to coating has a roughness Ra of max. 0.5 µm.

## Revendications

1. Tôle électrique à grains orientés avec un revêtement isolant électriquement constitué d'un réseau amorphe de carbone et d'hydrogène.

2. Tôle électrique à grains orientés selon la revendication 1, **caractérisée en ce que** le revêtement isolant électriquement est dopé avec au moins l'un des éléments Si, O, N, B ou F.

3. Tôle électrique à grains orientés selon la revendication 2, **caractérisée en ce que** les éléments de dopage dans le revêtement isolant électriquement sont contenus à raison de 1 à 20 % d'atomes.

4. Tôle électrique à grains orientés selon l'une des revendications 1 à 3, **caractérisée en ce que** le revêtement isolant électriquement exerce une contrainte de traction d'au moins 8 MPa.

5. Tôle électrique à grains orientés selon l'une des revendications 1 à 4, **caractérisée en ce qu'**une couche intercalaire améliorant l'adhérence est disposée entre le revêtement isolant électriquement et le substrat en tôle.

6. Tôle électrique à grains orientés selon la revendication 5, **caractérisée en ce qu'**au moins une couche intercalaire améliorant l'adhérence est constituée d'un réseau de Si-C-O-H.

7. Tôle électrique à grains orientés selon l'une des revendications 5 ou 6, **caractérisée en ce qu'**au moins une couche intercalaire améliorant l'adhérence est constituée d'un réseau de Si-C-H.

8. Tôle électrique à grains orientés selon l'une des revendications 5 à 7, **caractérisée en ce qu'**au moins une couche intercalaire améliorant l'adhérence est constituée de titane ou d'un composé contenant du titane.

9. Tôle électrique à grains orientés selon la revendication 8, **caractérisée en ce que** la liaison contenant du titane est du nitrure de titane.

10. Tôle électrique à grains orientés selon l'une des revendications 1 à 9, **caractérisée en ce que** le revêtement présente une résistance diélectrique de surface d'au moins 10 ohms *cm².

11. Tôle électrique à grains orientés selon l'une des revendications 1 à 10, **caractérisée en ce que** dans le cas d'une épaisseur de tôle de 0,30 mm elle présente une perte par démagnétisation (à une fréquence de 50 hertz et une polarisation de 1,7 Tesla) de P_{1,7} ≤ 0,90 W/kg, pour une épaisseur de tôle de 0,27 mm une perte par démagnétisation de P_{1,7} ≤ 0,80 W/kg et pour une épaisseur de tôle de 0,23 mm, une perte par démagnétisation de P_{1,7} ≤ 0,70 W/kg.

12. Tôle électrique à grains orientés selon l'une des revendications 1 à 11, **caractérisée en ce que** le substrat en tôle contient de 2,5 % en poids à 4,0 % en poids de silicium, jusqu'à 0,20 % en poids de manganèse, jusqu'à 0,50 % de cuivre, jusqu'à 0,065 % en poids d'aluminium, jusqu'à 0,0150 % en poids d'azote et au moins 90 % en poids de fer.

13. Tôle électrique à grains orientés selon la revendication 12, **caractérisée en ce qu'**en outre au moins l'un des éléments Cr, Ni, Mo, P, As, Sn, Sb, Se, Te, B ou Bi est contenu respectivement jusqu'à 0,2 % en poids.

14. Procédé de fabrication d'une tôle électrique à grains orientés avec un revêtement isolant électriquement constitué d'un réseau amorphe de carbone et d'hydrogène selon l'une des revendications 1 à 13, **caractérisé en ce que** le revêtement du substrat en tôle en forme de bande avec le revêtement isolant électriquement est réalisé par un procédé de passage continu de la bande.

15. Procédé selon la revendication 14, **caractérisé en ce que** le revêtement du substrat en tôle avec des couches intercalaires améliorant l'adhérence selon les revendications 5 à 9 est réalisé par un procédé de passage continu de la bande avant l'application du revêtement isolant électriquement.

16. Procédé selon l'une des revendications 14 ou 15, **caractérisé en ce qu'**au moins l'une des étapes de revêtement s'effectue au moyen d'un procédé CVD (chemical vapour deposition) .

17. Procédé selon l'une des revendications 14 à 16, **caractérisé en ce qu'**au moins l'une des étapes de revêtement s'effectue au moyen d'un procédé PVD (physical vapour deposition).

18. Procédé selon la revendication 17, **caractérisé en ce qu'**au moins l'une des étapes de revêtement s'effectue au moyen d'un procédé PVD activé par plasma.

19. Procédé selon la revendication 17 ou 18, **caractérisé en ce qu'**au moins l'une des étapes de revêtement s'effectue au moyen d'un procédé de décharge lumineuse à cathode creuse.

20. Procédé selon l'une des revendications 14 à 19, **caractérisé en ce que** la surface du substrat en acier présente avant le revêtement une rugosité Ra de 0,5 µm au maximum.
